# EUROPEAN PATENT SPECIFICATION

(11) **EP 4 553 836 B1**
(45) Date of publication and mention of the grant of the patent: **08.07.2026**
(21) Application number: 24209562.8
(22) Date of filing: 29.10.2024
(51) Int. Cl.: H10D 30/00, H10D 30/01, H10W 20/00, G11C 5/06, B82Y 10/00

(54) **SEMICONDUCTOR DEVICE INCLUDING SELF-ALIGNED BACKSIDE CONTACT STRUCTURE AND ETCH STOP LAYER**
HALBLEITERBAUELEMENT MIT SELBSTAUSGERICHTETER RÜCKSEITENKONTAKTSTRUKTUR UND ÄTZSTOPPSCHICHT
DISPOSITIF SEMI-CONDUCTEUR COMPRENANT UNE STRUCTURE DE CONTACT ARRIÈRE AUTO-ALIGNÉE ET UNE COUCHE D'ARRÊT DE GRAVURE

(30) Priority: 06.11.2023 US 202363547450 P; 27.06.2024 US 202418756482
(43) Date of publication of application: 14.05.2025
(73) Proprietor: Samsung Electronics Co., Ltd., Suwon-si, Gyeonggi-do 16677 (KR)
(72) Inventor: HONG, Wonhyuk, San Jose, CA, 95134 (US); LEE, Jongjin, San Jose, CA, 95134 (US); KIM, Tae Sun, San Jose, CA, 95134 (US); SEO, Kang-ill, San Jose, CA, 95134 (US)
(74) Representative: Kuhnen & Wacker Patent- und Rechtsanwaltsbüro PartG mbB

(56) References cited:
- EP-A2- 4 480 903
- US-A1- 2022 028 786
- US-A1- 2023 290 844

## Description

### BACKGROUND

### 1. Field

Apparatuses and methods related to the disclosure relate to a semiconductor device in which a backside contact structure is formed in a self-aligned manner.

### 2. Description of the Related Art

A backside power distribution network (BSPDN) for a semiconductor device has been introduced to address a heavy traffic of signal lines at a front side of the semiconductor device. The BSPDN includes connection structures formed at a back side of a semiconductor device. Here, the front side refers to a side where a transistor is formed with respect to a top surface of a substrate, and the back side refers to a side opposite to the front side.

The BSPDN formed on a back side of a semiconductor device includes a backside contact structure connected to a bottom surface of a source/drain region of a field-effect transistor such as a nanosheet transistor or a fin field-effect transistor (FinFET). This backside contact structure connects the source/drain region to a voltage source or another circuit element for signal routing through a backside metal line. The FinFET has one or more fin structures as a channel structure of the transistor. The fin structures vertically protrude from a substrate and horizontally extend, and at least three surfaces thereof are surrounded by a gate structure. In some embodiments of the FinFET, a various number of surfaces thereof are surrounded by a gate structure. The nanosheet transistor is characterized by one or more nanosheet channel layers as a channel structure of the transistor. The nanosheet channel layers vertically stacked based on a substrate and horizontally extend, and all four surfaces of each of the nanosheet channel layers are surrounded by a gate structure. The nanosheet transistor is referred to as gate-all-around (GAA) transistor, or as a multi-bridge channel field-effect transistor (MBCFET).

However, formation of the backside contact structure at a back side of a semiconductor device including a plurality of field-effect transistors is a challenging process due to various risks including possible misalignment of the backside contact structure with the source/drain region and a short-circuit between the backside contact structure and neighboring elements of the semiconductor device.

US 2022/028786 A1 relates to a semiconductor device and its manufacturing method, featuring vertically stacked channel layers wrapped by a metal gate, with a backside contact structure-including a conductive feature and backside spacer-connecting an epitaxial source/drain region to a power rail through a dielectric layer to enhance isolation and reduce resistance.

US 2023/290844 A1 relates to integrated circuit structures and fabrication methods featuring backside self-aligned conductive source or drain contacts that penetrate laterally into an epitaxial source/drain region adjacent to a vertical stack of horizontal nanowires without wrapping around it.

EP 4 480 903 A2 is prior art according to Art. 54(3) EPC and discloses a semiconductor device and corresponding manufacturing method in which a channel structure connecting first and second source/drain regions is surrounded by a gate, and a self-aligned backside contact structure is formed below one source/drain region using backside spacers and/or an isolation stack comprising stacked isolation and substrate layers.

Information disclosed in this Background section may be known to or derived by the inventors before or during the process of achieving the embodiments of the present application, or is technical information acquired in the process of achieving the embodiments. Therefore, it may contain information that does not form the prior art that is already known to the public.

### SUMMARY

The disclosure provides a semiconductor device in which a backside contact structure is formed in a self-aligned manner based on a couple of etch stop layers. The semiconductor device may include a substrate layer which along with one of the etch-stop layers performs a role of the BDI layer. Further, the semiconductor device does not have a placeholder structure in a backside isolation structure.

A semiconductor device according to the claimed invention is defined by independent claim 1, and a method of manufacturing a semiconductor device according to the claimed invention is defined by independent claim 11. Refinements of the semiconductor device and the method are defined by the dependent claims.

### BRIEF DESCRIPTION OF DRAWINGS

Example embodiments of the disclosure will be more clearly understood from the following detailed description taken in conjunction with the accompanying drawings in which:
FIGS. 1A and 1B illustrate a semiconductor device including a backside contact structure according to a comparative example;
FIG. 2 illustrate a semiconductor device including a self-aligned backside contact structure and etch-stop layers, according to one or more embodiments of the claimed invention;
FIGS. 3A-3S illustrate intermediate semiconductor devices obtained after respective steps of manufacturing a semiconductor device including a self-aligned backside contact structure and etch-stop layers, according to one or more embodiments of the claimed invention;
FIGS. 4A and 4B illustrate a flowchart describing a method of manufacturing a semiconductor device including a self-aligned backside contact structure and etch-stop layers in reference to FIGS. 3A-3S, according to one or more embodiments of the claimed invention; and
FIG. 5 is a schematic block diagram illustrating an electronic device including a self-aligned backside contact structure and etch-stop layers as shown in FIG. 2, according to one or more embodiments of the claimed invention.

### DETAILED DESCRIPTION

The embodiments of the disclosure described herein are example embodiments, and thus, the disclosure is not limited thereto, and may be realized in various other forms within of the scope as defined by the appended claims. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. For example, a 1^{st} element described in descriptions of embodiments could be termed a 2^{nd} element in one set of claims and a 1^{st} element in another set of claims, without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" or "equal" is used to compare a dimension of two or more elements, the term may cover a "substantially same" or "substantially equal" dimension. Further, when a term "coplanar" or "aligned" is used to compare a positional relationship between two or more elements, the term may also cover "a substantially coplanar" or "substantially aligned" positional relationship.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity. Thus, it is to be understood that such schematic illustrations may not reflect actual images when any of the structures described herein are examined through scanning electron microscopy (SEM), transmission electron microscopy (TEM), focused ion beam (FIB) microscopy, etc.

For the sake of brevity, conventional elements, structures or layers of semiconductor devices including a nanosheet transistor, a fin field-effect transistor, and materials forming the same may or may not be described in detail herein. For example, a certain isolation layer, a buffer layer or a silicide layer of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments.

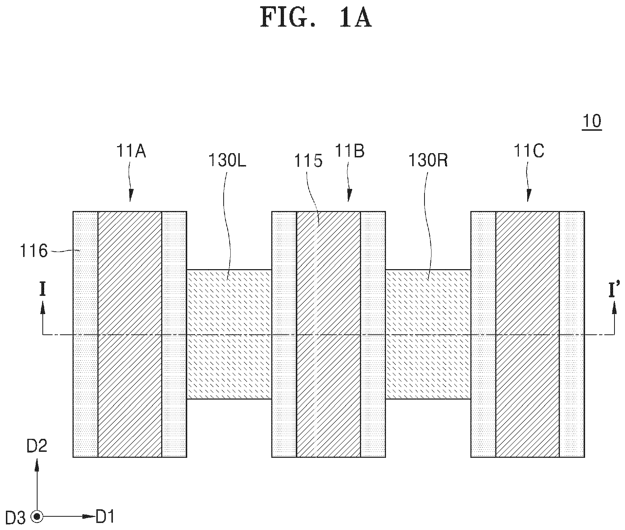

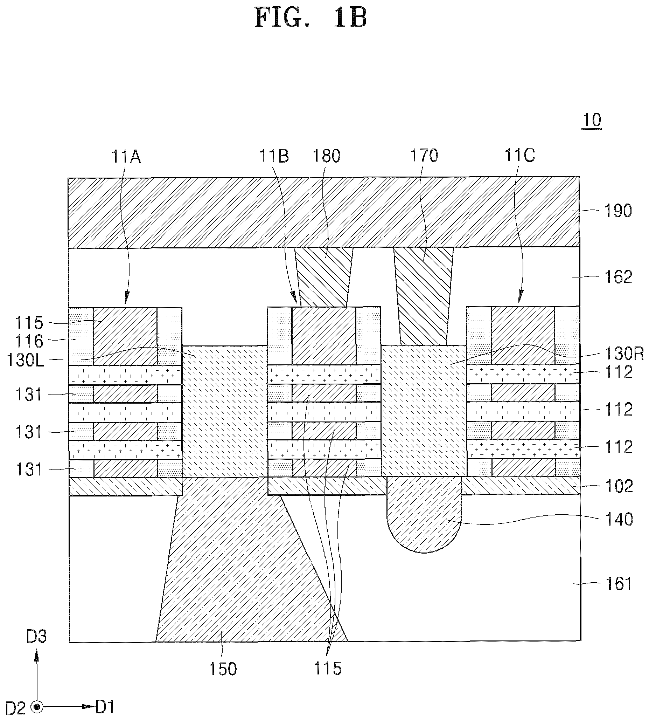

FIGS. 1A and 1B illustrate a semiconductor device including a backside contact structure, according to one or more examples which illustrate aspects of the claimed invention but which are not according to the claimed invention.

FIG. 1A is a simplified plan view of a semiconductor device 10, and FIG. 1B illustrates a cross-section view of the semiconductor device 10 of FIG. 1A along a line I-I' shown therein in a D1 direction, according to one or more embodiments. It is to be understood here that the D1 direction is a channel-length direction intersecting a D2 direction, which is a channel-width direction or a cell-height direction, and a D3 direction is a vertical direction intersecting the D1 direction and the D2 direction.

Referring to FIG. 1A and 1B, the semiconductor device 10 may include 1^{st} to 3^{rd} channel stacks 11A-11C each of which includes a plurality of channel layers 112 vertically stacked on a front side of the semiconductor device 10 and surrounded by a gate structure 115. Each of the channel layers 112 may be referred to as a nanosheet or nanoribbon extended in the D1 direction.

The channel layers 112 of each of the channel stacks 11A-11C surrounded by the gate structure 115 may form a channel structure which connects source/drain regions formed at both sides of the channel structure to each other to form a field-effect nanosheet transistor. For example, a field-effect nanosheet transistor may be formed by a channel structure including the channel layers 112, the gate structure 115 surrounding the channel structure, and a 1^{st} source/drain region 130L and a 2^{nd} source/drain region 130R connected to each other by the channel layers 112 of the 2^{nd} channel stack 11B.

One or more materials forming the channel layers 112 may include, for example, silicon (Si), silicon germanium (SiGe). The gate structure 115 may be formed of one or more materials including, for example, copper (Cu), aluminum (Al), cobalt (Co), tungsten (W), titanium (Ti), tantalum (Ta) or their combination. Each of the source/drain regions 130L and 130R may include one or more materials, for example, silicon (Si), silicon germanium (SiGe) doped with impurities. The source/drain regions 130L and 130R may be either a p-type or an n-type.

Each of the channel stacks 11A-11C may also include inner spacers 131 formed at side surfaces of lower portions of the gate structure 115 below the channel layers 112 in the D3 direction. Gate spacers 116 may be formed at side surfaces of an upper portion of the gate structure 115 in each of the channel stacks 11A-11C. The inner spacers 131 may isolate the lower portions of the gate structure 115 from the source/drain regions 130L and 130R, and the gate spacers 116 may isolate the upper portion of the gate structure 115 from the source/drain regions 130L and 130R. One or more materials forming the inner spacers 131 and the gate spacers 116 may include, for example, silicon nitride (e.g., SiN, Si₃N₄) or silicon oxide (e.g., SiO₂), not being limited thereto.

The semiconductor device 10 may also include a plurality of contact structures including a frontside contact structure 170, a gate contact structure 180, and a backside contact structure 150. The frontside contact structure 170 may be formed on a top surface of the 2^{nd} source/drain region 130R to connect the 2^{nd} source/drain region 130R to a voltage source or another circuit element through a back-end-of-line (BEOL) structure 190 including one or more metal lines and vias. The gate contact structure 180 may be formed on a top surface of the gate structure 115 to receive a gate input signal for the gate structure 115 through the BEOL structure 190. The frontside contact structure 170 and the gate contact structure 180 may be isolated from each other through a frontside isolation structure 162. The backside contact structure 150 may be formed on a bottom surface of the 1^{st} source/drain region 130L to connect the 1^{st} source/drain region to a voltage source or another circuit element. The backside contact structure 150 may be isolated from other circuit elements by a backside isolation structure 161. The contact structures 170, 180 and 150 may each be formed of one or more materials such as copper (Cu), aluminum (Al), tungsten (W), ruthenium (Ru), molybdenum (Mo), etc. The frontside isolation structure 162 and the backside isolation structure 161 may each be formed of a low-k dielectric material such as silicon oxide (e.g., SiO₂, etc.).

In the meantime, the semiconductor device 10 may include a placeholder structure 140 formed below the 2^{nd} source/drain region 130R. This placeholder structure 140 may have been formed to provide a space for formation of another backside contact structure therein in a process of manufacturing the semiconductor device 10. There also may have been another placeholder structure below the 1^{st} source/drain region 130L which was removed and replaced by the backside contact structure 150. Unlike this removed placeholder structure, the placeholder structure 140 below the 2^{nd} source/drain region 130R may have remained there without being replaced by another backside contact structure because the frontside contact structure 170 is formed on the 2^{nd} source/drain region 130R to connect the 2^{nd} source/drain region 130R to a voltage source or another circuit element through the BEOL structure 190. The placeholder structure 140 may be formed of a material such as silicon germanium (SiGe), not being limited thereto.

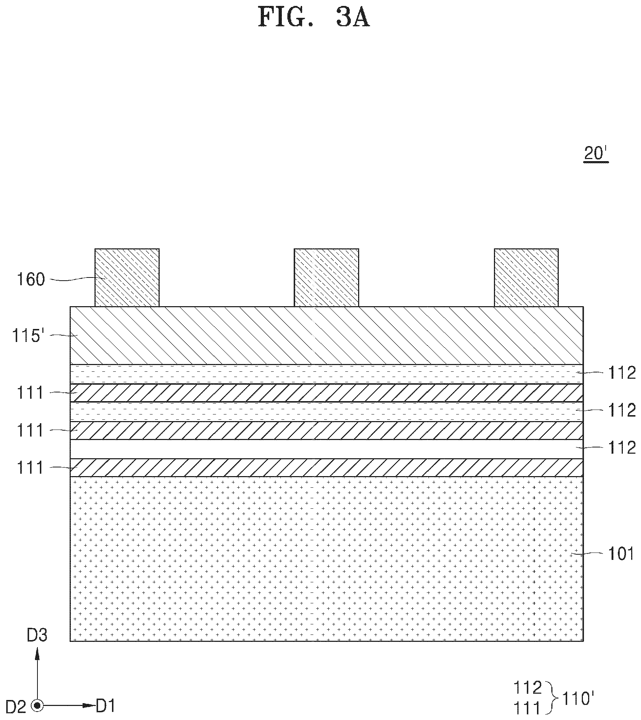

The placeholder structure 140 and the backside contact structure 150 may be formed in and surrounded by the backside isolation structure 161 which may have replaced a substrate 101 formed of silicon (Si), not being limited thereto, in the process of manufacturing the semiconductor device 10 (see FIGS. 3A-3S).

A bottom diffusion isolation (BDI) layer 102 may be formed to prevent current leakage from the gate structure 115 and the source/drain regions 130L and 130R to the backside isolation structure 161. The BDI layer 102 may also protect the gate structure 115 and the inner spacer 131 in a backside process of forming the backside isolation structure 161 by removing and replacing the substrate 101 with the backside isolation structure 161. The BDI layer 102 may include silicon nitride, silicon carbon nitride (SiCN) or silicon boron carbon nitride (SiBCN), not being limited thereto. However, formation of the BDI layer 102 is a challenging step in the process of manufacturing the semiconductor device 10 at least because the BDI layer 102 is formed by replacing a certain sacrificial layer formed below the channel layers 112 and other sacrificial layers removed and replaced by the lower portions of the gate structure 115 in a complicated frontside process when the semiconductor device 10 is manufactured.

Formation of the backside contact structure 150 through the backside isolation structure 161 in the process of manufacturing the semiconductor device 10 also exposes a risk of misalignment between the backside contact structure 150 and the 1^{st} source/drain region 130L, and a risk of short-circuit with the placeholder structure 140 formed of silicon germanium (SiGe), as shown in FIG. 1B.

Thus, one or more other embodiments are provided herebelow to address the foregoing difficulties in the formation of the BDI layer 102 and the backside contact structure 150.

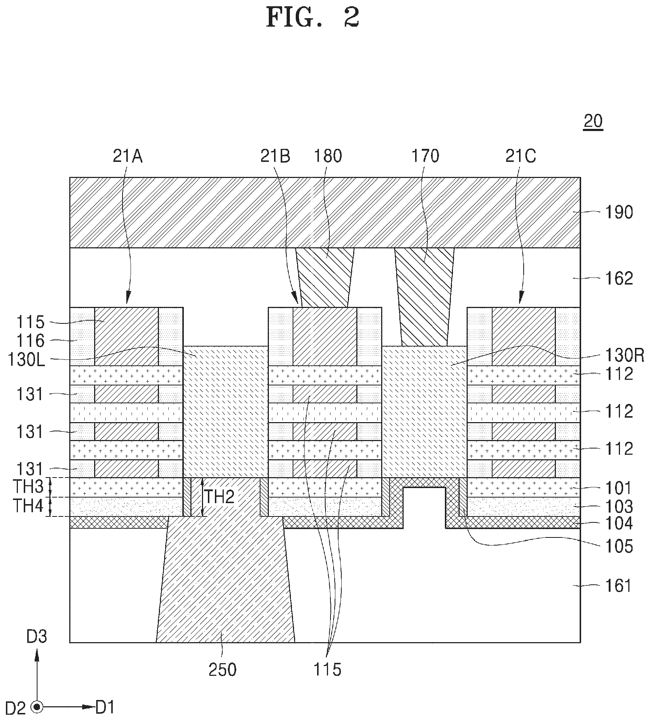

FIG. 2 illustrate a semiconductor device including a self-aligned backside contact structure and etch-stop layers, according to one or more embodiments of the claimed invention.

Referring to FIG. 2, a semiconductor device 20 may include structural elements similar to those of the semiconductor device 10 of FIGS. 1A and 1B. However, the semiconductor device 20 does not have the BDI layer 102 and the placeholder structure 140 included in the semiconductor device 10, and instead, additional structural elements are formed below each of 1^{st} to 3^{rd} channel stacks 21A-21C in the backside isolation structure 161. Further, a backside contact structure 250 may be formed in the backside isolation structure 161 in a manner different from that of the backside contact structure 150 of the semiconductor device 10.

Herebelow, duplicate descriptions about the structural elements that are common to the semiconductor devices 10 and 20 may be omitted while different aspects of the semiconductor device 20 are described.

In the semiconductor device 20, a substrate layer 101 may be formed on bottom surfaces of the gate structure 115 and the lowermost inner spacers 131, which may be horizontally coplanar and aligned, in each of the channel stacks 21A-21C. On a bottom surface of the substrate layer 101 may be formed a 1^{st} etch-stop layer 103, and on a bottom surface of the 1^{st} etch-stop layer may be formed a 2^{nd} etch-stop layer 104. A side surface of the 1^{st} etch-stop layer 103 may be vertically aligned or coplanar with side surfaces of the substrate layer 101, the channel layers 112, the inner spacers 131, and the gate spacer 116 thereabove. On the side surfaces of the 1^{st} etch-stop layer 103 and the substrate layer 101 may be formed a backside spacer 105.

Further, a 2^{nd} etch-stop layer 104 may be formed on a bottom surface of the 1^{st} etch-stop layer 130 in each channel stack 21A-21C. The 2^{nd} etch-stop layers 104 formed on the bottom surface of the 1^{st} etch-stop layer 103 in the 2^{nd} channel stack 21B may be continuously extended to the bottom surface of the 1^{st} etch-stop layer 103 in the 3^{rd} channel stack 21C along bottom surfaces and side surfaces of the backside spacers 105 between the two channel stacks 21B and 21C and a bottom surface of the 2^{nd} source/drain region 130R. However, the 2^{nd} etch-stop layer 104 on the bottom surface of the 1^{st} etch-stop layer 103 in the 2^{nd} channel stack 21B may not be extended to a bottom surface of the 1^{st} etch-stop layer 103 in the 1^{st} channel stack 21A because the backside contact structure 250 is formed to contact the bottom surface of the 1^{st} source/drain region 130L through the backside isolation structure 161. Thus, a disconnected portion of the 2^{nd} etch-stop layer 104 may be formed on the bottom surface of the 1^{st} etch-stop layer 103 in the 1^{st} channel stack 21A.

In the semiconductor device 20, the backside contact structure 250 may be self-aligned to the 1^{st} source/drain region 130L through the backside isolation structure 161 based on the substrate layer 101, the 1^{st} etch-stop layer 103, the 2^{nd} etch-stop layer 104, and a backside spacer 105 in each of the 1^{st} channel stack 21A and the 2^{nd} channel stack 21B. In a case that the backside contact structure 250 is self-aligned based on these layers, a risk of misalignment of the backside contact structure 250 with the 1^{st} source/drain region 130L may be prevented or reduced.

Also, the semiconductor device 20 does not include the BDI layer 102 which is formed in the semiconductor device 10 to protect and support the inner spacers 131 and the lower portions of the gate structure 115 in a backside process of forming the backside contact structure 150 and prevent current leakage from the gate structure 115 into the backside isolation structure 161. Instead, the substrate layers 101 may protect and support the inner spacers 131 and the lower portions of the gate structure 115 in a backside process of forming the backside contact structure 250. The substrate layers 101 are structures remaining after a substrate 101 is partially removed and replaced by the backside isolation structure 161 in the backside process. However, as the substrate layer 101 may not suppress current leakage from the gate structure 115 in each channel stack 21A-21C, the 1^{st} etch-stop layer 103 may be formed under the substrate layer 101 as dielectric passivation layer. Thus, the substrate layer 101 and the 1^{st} etch-stop layer 103 may be formed in each channel stack 21A-21C of the semiconductor device 20 to form the functions of the BDI layer 102 of the semiconductor device 10. As the BDI layer 102 in the semiconductor device 10 is not necessary in the semiconductor device 20, manufacturing simplicity may be achieved in manufacturing the semiconductor device 20.

Further, the 1^{st} etch-stop layers 103 along with the backside spacers 105 may isolate the backside contact structure 250 from the substrate layer 101. Thus, the substrate layer 101 may have a thickness TH3 which is smaller than a thickness TH2 of the backside spacer 105 in the D3 direction. The 1^{st} etch-stop layer 103 may have a thickness TH4 which is also smaller than the thickness TH2 of the backside spacer 105 in the D3 direction. Top surfaces of the substrate layers 101, the backside spacers 105 and the backside contact structure 250 may be horizontally aligned or coplanar with each other. Herein, the D3 direction may refer to a direction in which the gate structure 115, the substrate layer 101, the 1^{st} etch-stop layer 103 and the 2^{nd} etch-stop layer 104 are arranged to form the semiconductor device 20.

Thus, the substrate layer 101 and the 1^{st} etch-stop layer 103 in each of the 1^{st} channel stack 21A and the 2^{nd} channel stack 21B may be formed at one side of the backside spacer 105 and an upper portion of the backside contact structure 250 may be at the other side of the backside spacer 105.

The 2^{nd} etch-stop layer 104 may be used to guide patterning of a backside contact recess leading to the bottom surface of the 1^{st} source/drain region 130L in the backside isolation structure 161 so that the backside contact structure 250 can be formed in the backside contact recess formed based on the 2^{nd} etch-stop layer 104 without relying on a placeholder structure. Thus, the backside contact structure 250 may take a structural form penetrating into the 2^{nd} etch-stop layer 104 to contact the bottom surface of the 1^{st} source/drain region 130L.

As the BDI layer 102 in the semiconductor device 10 is not necessary in the semiconductor device 20, manufacturing simplicity may be achieved in manufacturing the semiconductor device 20.

The semiconductor device 20 may also be characterized in that the placeholder structure 140 in the backside isolation structure 161 may have been removed in the backside process, thereby removing a risk of a short-circuit between the removed placeholder structure 140 and the backside contact structure 250.

The backside spacer 105 may be formed of silicon nitride or a composite thereof (e.g., SiN, Si₃N₄, SiBCN, SiCN, etc.), not being limited thereto. The 1^{st} etch-stop layer 103 may also be formed of silicon nitride or silicon oxide (e.g., SiN, Si₃N₄, SiO₂, etc.), not being limited thereto, which may be the same or different from the backside spacer 105. The 2^{nd} etch-stop layer 104 may be formed of aluminum nitride or aluminum oxide (AIN, AlOₓ, etc.), not being limited thereto, which has etch selectivity against the 1^{st} etch-stop layer 103 of silicon nitride or silicon oxide.

Herebelow, a method of manufacturing the semiconductor device 20 including the self-aligned backside contact structure 250 is described.

FIGS. 3A-3S illustrate intermediate semiconductor devices obtained after respective steps of manufacturing a semiconductor device including a self-aligned backside contact structure and etch-stop layers, according to one or more embodiments of the claimed invention. As the semiconductor device manufactured through the respective steps may be the same as or correspond to the semiconductor device 20 shown in FIG. 2, duplicate descriptions thereof may be omitted and the same reference numbers may be used in the descriptions herebelow.

Referring to FIG. 3A, an intermediate semiconductor device 20' may include a substrate 101 on which an initial channel stack 110', a dummy gate structure 115' and three hard mask patterns 160 are formed in this order.

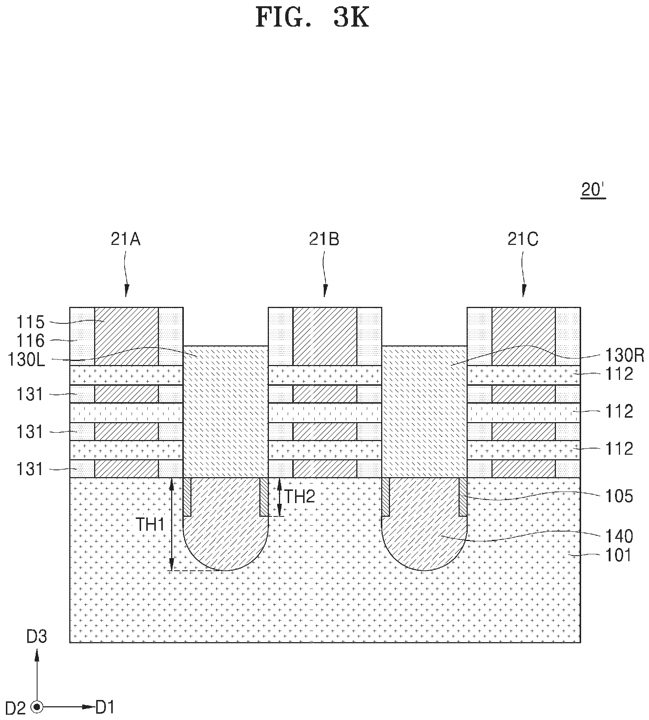

The initial channel stack 110' may include sacrificial layers 111 and channel layers 112 epitaxially grown one after another to be stacked on the substrate 101. The sacrificial layers 111 may each be formed of silicon germanium (SiGe), and the channel layers 112 may include silicon (Si) or SiGe. The sacrificial layers 111 are termed as such as these layers are formed therein to support formation of other structure elements of the semiconductor device 20 (FIG. 2) to be manufactured from the intermediate semiconductor device 20' and will be removed and replaced by a gate structure in a later step (FIG. 3K) in a process of the semiconductor device 20.

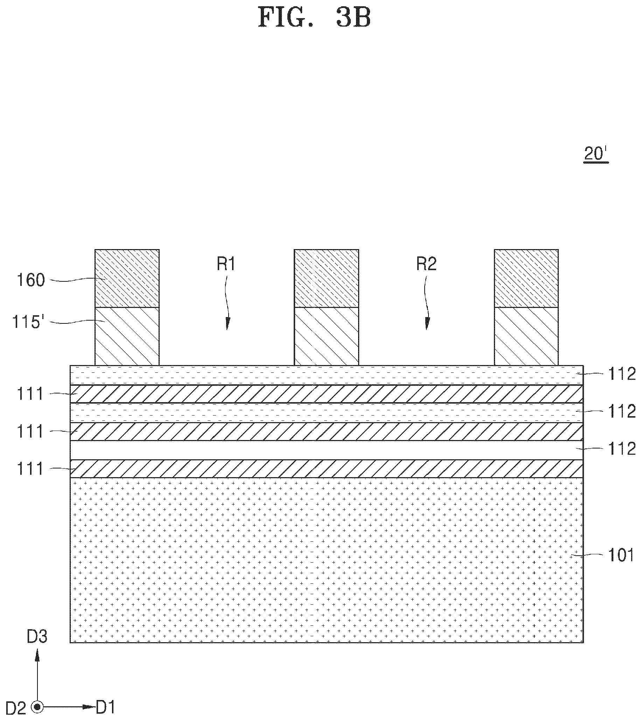

The dummy gate structure 115' may be formed on the uppermost channel layer 112 and planarized through, for example, chemical mechanical polishing (CMP), not being limited thereto. The hard mask patterns 160 may be formed on the dummy gate structure 115' at positions where a dummy gate structure 115' for each of the 1^{st} to 3^{rd} channel stacks 11A-11C shown in FIGS. 1A and 1B is to be patterned out there below in a next step (FIG. 3B). The dummy gate structure115' may be formed of a material such as polycrystalline silicon or amorphous silicon, and the hard mask patterns 160 may be formed of a material such as silicon nitride or a composite thereof (e.g., SiN, Si₃N₄, SiBCN, SiNC, SiNOC, etc.).

Referring to FIG. 3B, the dummy gate structure 115' may be patterned to form three dummy gate structures 115' based on the hard mask patterns 160.

The formation of the three dummy gate structures 115' may be performed through, for example, dry etching such as reactive ion etching (RIE) based on the hard mask patterns 160. When the dummy gate structures 115' are formed based on the hard mask patterns 160, a top surface of the initial channel stack 110', for example, a top surface of the uppermost channel layer 112, may be exposed through a 1^{st} recess R1 and a 2^{nd} recess R2.

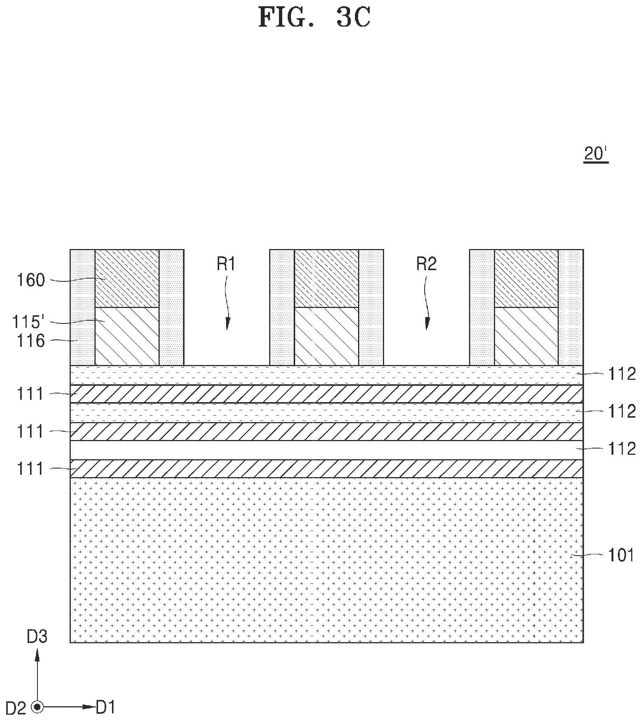

Referring to FIG. 3C, gate spacers 116 may be formed on side surfaces of each dummy gate structure 115' with the hard mask pattern 160 thereon.

The formation of the gate spacers 116 may be performed through, for example, atomic layer deposition (ALD), chemical vapor deposition (CVD), plasma enhanced CVD (PECVD), physical vapor deposition (PVD), or a combination thereof, not being limited thereto. A material such as silicon nitride (e.g., SiN, Si₃N₄) or silicon oxide (e.g., SiO₂), not being limited thereto, forming the gate spacers 116 may be deposited on the entire intermediate semiconductor device 20' obtained in the previous step (FIG. 3B), and etched back to leave the gate spacer material only on the side surfaces of each dummy gate structure 115' with the hard mask pattern 160 thereon.

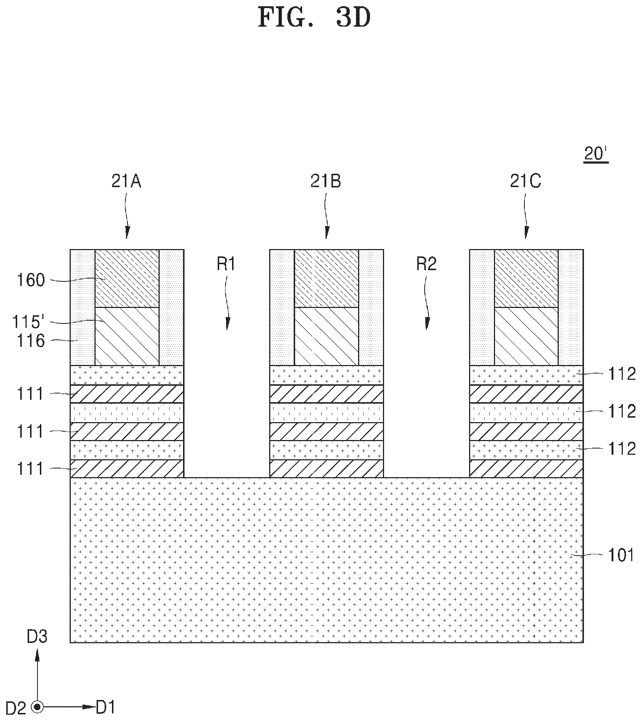

Referring to FIG. 3D, the initial channel stack 110' may be etched down through the recesses R1 and R2 based on the hard mask patterns 160 and the gate spacers 116 to form 1^{st} to 3^{rd} channel stacks 21A-21C exposing a top surface of the substrate 101 therebetween.

By the etch back of the initial channel stack 110', the 1^{st} recess R1 and the 2^{nd} recess R2 may be extended down to expose the top surface of the substrate 101 and side surfaces of the channel layers 112 and the sacrificial layers 111, thereby forming three channel stacks 21A-21C divided by the recesses R1 and R2. The etch back operation in this step may be performed through, for example, dry etching, not being limited thereto.

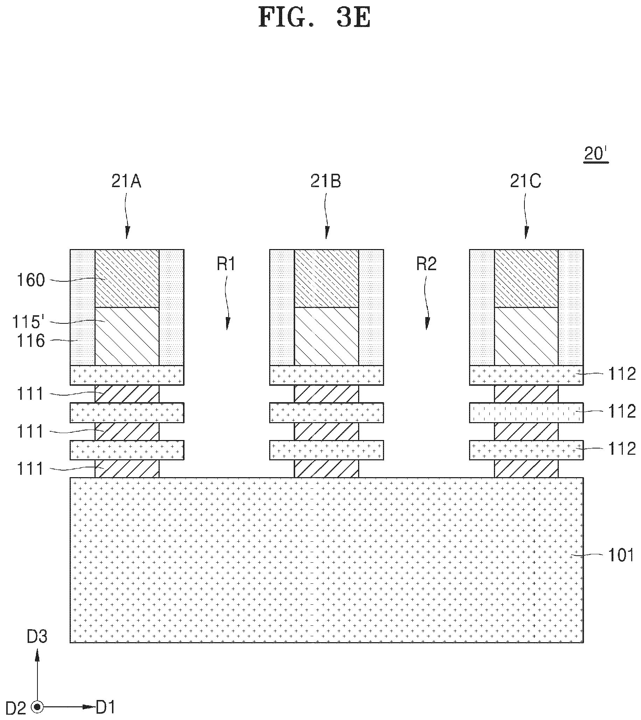

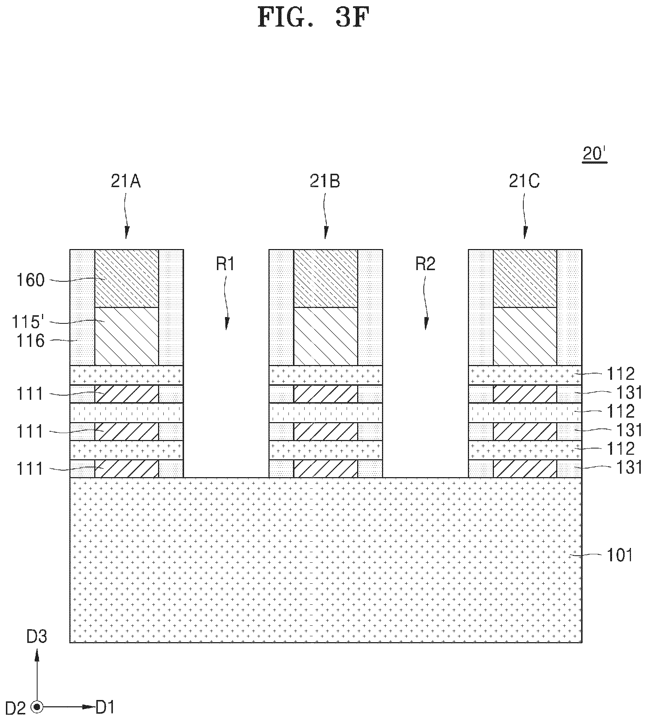

Referring to FIG. 3E, side surfaces of each of the sacrificial layers 111 in each of the channel stacks 21A-21C may be recessed to provide spaces for forming inner spacers 131 therein in a next step (FIG. 3F).

The etching operation in this step may be performed through, for example, selective wet etching or dry etching, not being limited thereto, remove only silicon germanium (SiGe) included in the sacrificial layers 111 against silicon (Si) included in the channel layers 112 and the substrate 101. For example, a mixture of hydrofluoric acid (HF) and nitric acid (HNO₃) may be used for the selective etching in this step.

Referring to FIG. 3F, inner spacers 131 may be formed at side surfaces of the recessed sacrificial layers 111.

Each of the inner spacer 131 may be formed such that side surfaces of the recessed sacrificial layer 111 exposed to the recesses R1 and R2 are vertically aligned with or coplanar with the side surfaces of the channel layers 112 and the gate spacers 116 also exposed to the recesses R1 and R2. The formation of the inner spacers 131 may be performed through, for example, atomic layer deposition (ALD) or any other suitable deposition process or electroplating.

The inner spacers 131 may be formed of a material such as silicon nitride (e.g., SiN, Si₃N₄) or silicon oxide (e.g., SiO₂), not being limited thereto, which may be the same as or different from that forming the gate spacers 116.

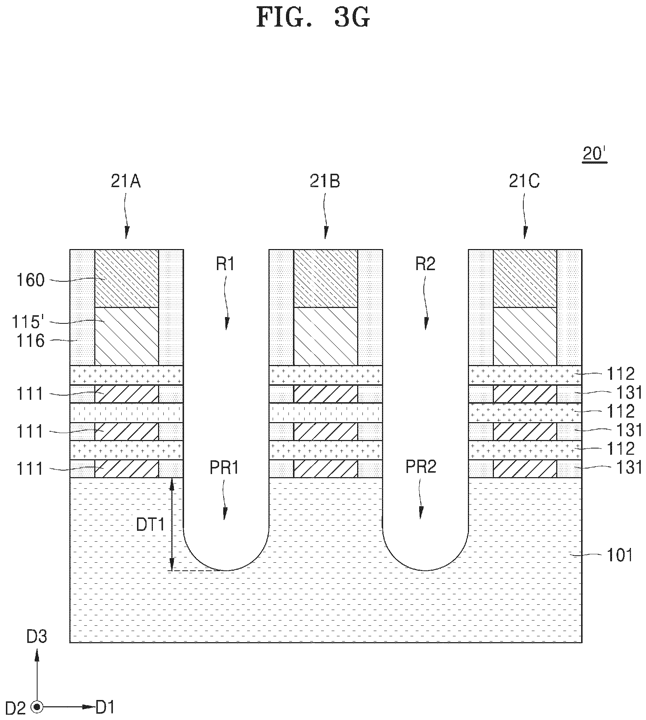

Referring to FIG. 3G, the substrate 101 of which the top surface is exposed through recesses R1 and R2 may be patterned to extend the recesses R1 and R2 below a level of the top surface of the substrate 101.

In this step, the substrate 101 exposed through the 1^{st} recess R1 and the 2^{nd} recess R2 may be patterned through, for example, dry etching, not being limited thereto, based on the hard mask patterns 160 and the gate spacers 116 such that a 1^{st} placeholder recess PR1 and a 2^{nd} placeholder recess PR2 each having a 1^{st} depth DT1 in the D3 direction are obtained in the substrate 101 below the level of the top surface of the substrate 101. The top surface of the substrate 101 may be horizontally coplanar or aligned with a bottom surface of the lowermost inner spacer 131 and a bottom surface of the lowermost sacrificial layer 111.

The 1^{st} placeholder recess PR1 and the 2^{nd} placeholder recess PR2 may be connected to the 1^{st} recess R1 and the 2^{nd} recess R2, respectively. In the recesses R1 and R2, source/drain regions will be formed, and placeholder structures will be formed in the placeholder recesses PR1 and PR2, in later steps.

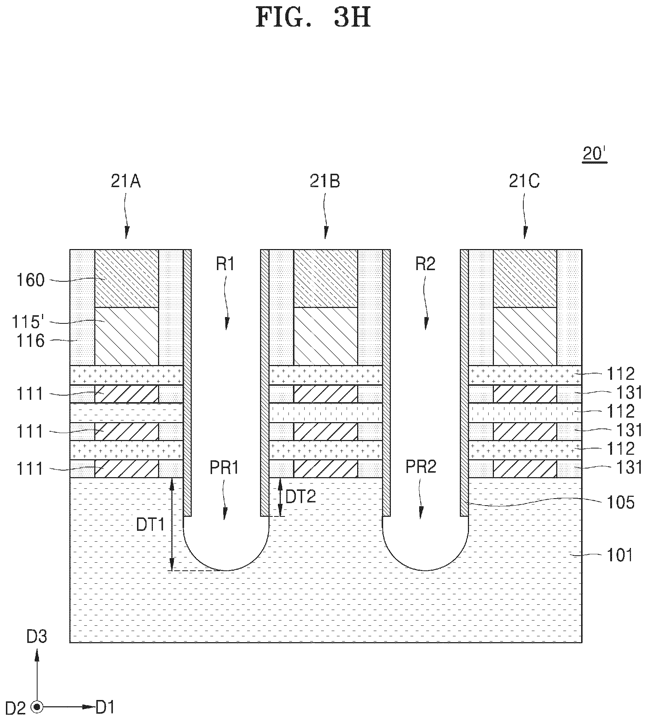

Referring to FIG. 3H, a backside spacer 105 may be formed along entire surfaces of the recesses R1 and R2 and the placeholder recesses PR1 and PR2, and partially removed below a 2^{nd} depth DT2 from the level of the top surface of the substrate 101 in each of the placeholder recesses PR1 and PR2.

The backside spacer 105 may be formed through, for example, depositing a material such as silicon nitride or a composite thereof (e.g., SiN, SiBCN, SiOCN, SiOC, etc.) on the entire surface of the recesses R1 and R2 and the placeholder recesses PR1 and PR2 through, for example, atomic layer deposition (ALD) and partially removing the deposited material below the 2^{nd} depth DT2 from the level of the top surface of the substrate 101 in each of the placeholder recesses PR1 and PR2. Here, the entire surface of each of the recesses R1 and R2 may include the side surfaces of the gate spacer 116, the channel layers 112 and the sacrificial layers 111 exposed through the recesses R1 and R2.

The partial removal of the backside spacer 105 in this step may include, for example, dry etching based on masking the backside spacer 105 except a portion below the 2^{nd} depth DT2 in each of the placeholder recesses PR1 and PR2.

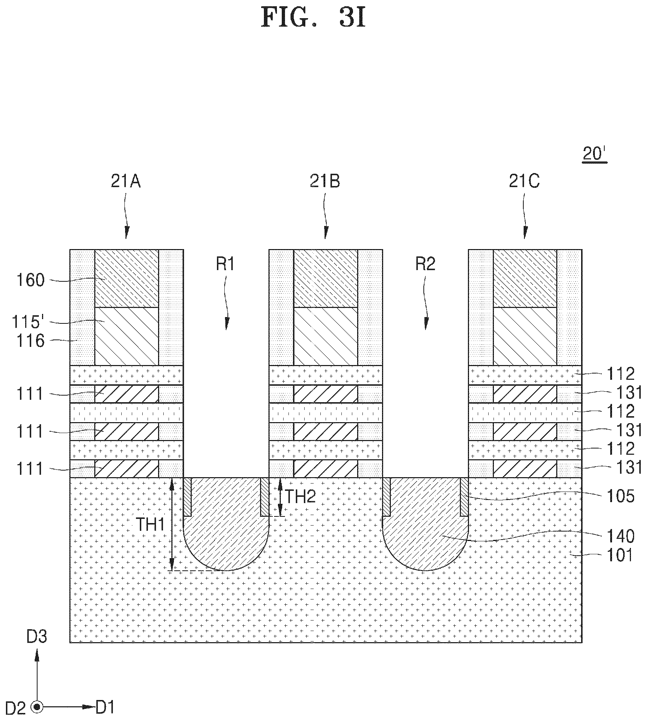

Referring to FIG. 3I, the backside spacer 105 may be further removed in part above the level of the top surface of the substrate 101, leaving only a portion of a 2^{nd} thickness TH2, in the D3 direction, below the level of the top surface of the substrate 101 in each of the placeholder recesses PR1 and PR2, and a placeholder structure 140 may be formed in each of the placeholder recesses PR1 and PR2 to have a 1^{st} thickness TH1 in the D3 direction.

The partial removal of the backside spacer 105 in this step may also be performed through, for example, dry etching based on masking a portion of the backside spacer 105 below the level of the top surface of the substrate 101 in each of the placeholder recesses PR1 and PR2. Thus, the backside spacer 105 may remain only by the masked portion, and the side surfaces of the channel layers 112, the sacrificial layers 111, and the gate spacer 115 may be exposed again in the recesses R1 and R2 above the remaining portion of the backside spacer 105, which has the 2^{nd} thickness TH2 equal to the 2^{nd} depth DT2 in the D3 direction.

Before or after the partial removal of the backside spacer 105 in this step, the placeholder structure 140 may be formed through, for example, PVD, CVD, PECVD, etc., not being limited thereto, of a material such as silicon germanium (SiGe) in each of the placeholder recesses PR1 and PR2 below the level of the top surface of the substrate 101. Alternatively or additionally, the placeholder structure 140 may be epitaxially grown from the substrate 101 exposed through each of the placeholder recesses PR1 and PR2.

The placeholder structure 140 may fill out each of the placeholder recesses PR1 and PR2 below the level of the top surface of the substrate 101 in which the backside spacer 105 is formed. Thus, the placeholder structure 140 may have the 1^{st} thickness TH1 which is equal to the 1^{st} depth DT1 of each of the placeholder recesses PR1 and PR2 in the D3 direction.

After the backside spacers 105 and the placeholder structure 140 are formed in each of the placeholder recesses PR1 and PR2, top surfaces of the backside spacers 105, the placeholder structures 140, and the substrate 101 may be horizontally aligned or coplanar with each other.

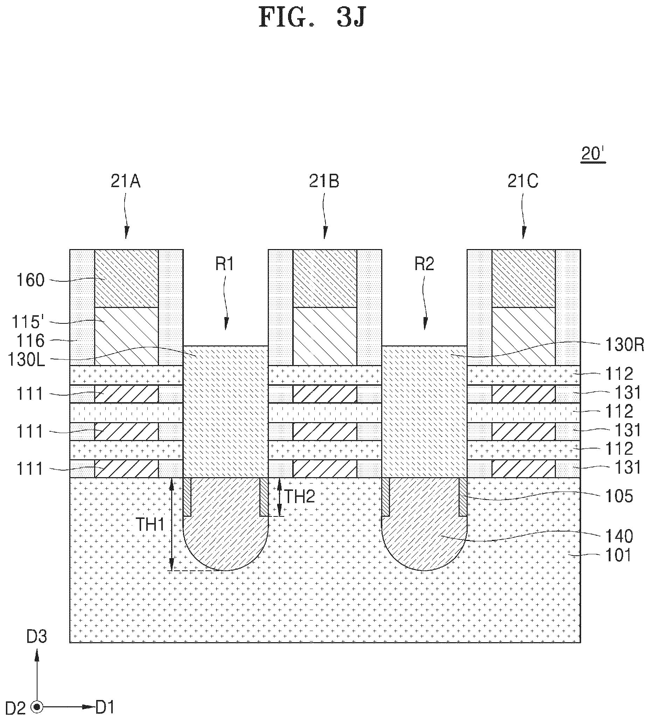

Referring to FIG. 3J, a 1^{st} source/drain region 130L and a 2^{nd} source/drain region 130R may be formed based on the channel layers 112.

The 1^{st} source/drain region 130L may be epitaxially grown from the channel layers 112 of the 1^{st} channel stack 21A and the 2^{nd} channel stack 21B in the 1^{st} recess R1, and the 2^{nd} source/drain region 130R may be epitaxially grown from the channel layers 112 of the 2^{nd} channel stack 21B and the 3^{rd} channel stack 21C in the 2^{nd} recess R2, while the sacrificial layers 111 in each of the channel stacks 21A-21C are blocked by the inner spacers 131 to prevent or suppress epitaxy from the sacrificial layers 111 of silicon germanium (SiGe).

The source/drain regions 130L and 130R may be doped in-situ with p-type impurities (e.g., boron, gallium, or indium) or n-type impurities (e.g., phosphorus, arsenic, or antimony). Alternatively or additionally, the impurities may be injected into the source/drain regions 130L and 130R after the epitaxial growth thereof.

After formation of the source/drain regions 130L and 130R, bottom surfaces of the source/drain regions 130L and 130R may contact top surfaces of the backside spacers 105 and the placeholder structures 140.

Referring to FIG. 3K, the hard mask patterns 160 may be removed, and the dummy gate structure 115' and the sacrificial layers 111 may be removed and replaced by the gate structure 115.

After formation of the source/drain regions 130L and 130R, the hard mask patterns 160 on the dummy gate structures 115' and portions of the gate spacers 116 at side surfaces of the hard mask patterns 160 may be removed by, for example, dry etching including stripping or ashing, not being limited thereto.

The dummy gate structure 115' and the sacrificial layers 111 may be removed through, for example, wet etching and/or dry etching, to form voids or spaces in each of the channel stacks 21A-21C, and the gate structure 115 may be formed in these voids or spaces through, for example, CVD, PVD, PECVD, ALD, or a combination thereof, not being limited thereto.

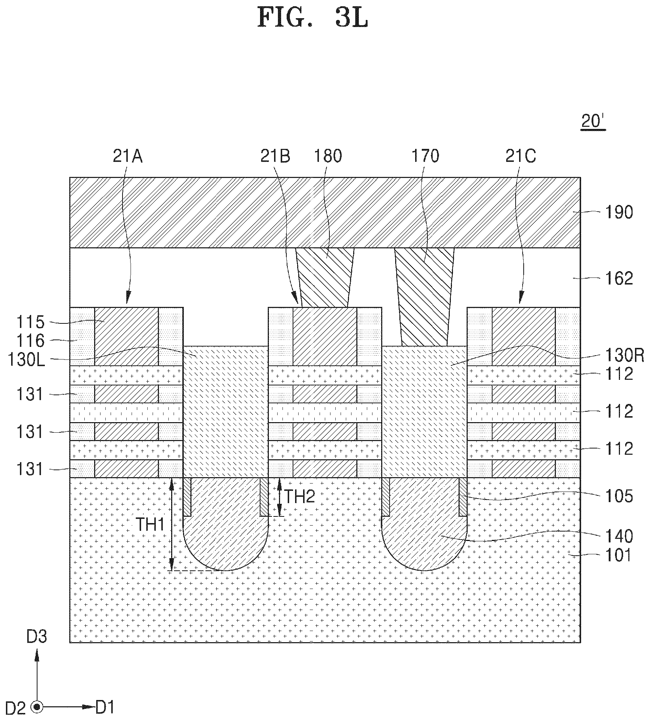

Referring to FIG. 3L, a frontside isolation structure 162, a frontside contact structure 170, a gate contact structure 180, and a BEOL structure 190 may be formed on the intermediate semiconductor device 20' obtained in the previous step (FIG. 3K).

The frontside isolation structure 162 may be formed on the intermediate semiconductor device 20' obtained in the previous step (FIG. 3K) including the source/drain regions 130L and 130R to isolate the source/drain regions 130L and 130R from each other and other circuit elements. The frontside isolation structure 162 may include silicon oxide (e.g., SiO₂, etc.). The formation of the frontside isolation structure 162 may be performed through, for example, PVD, CVD, PECVD, a combination thereof, not being limited thereto.

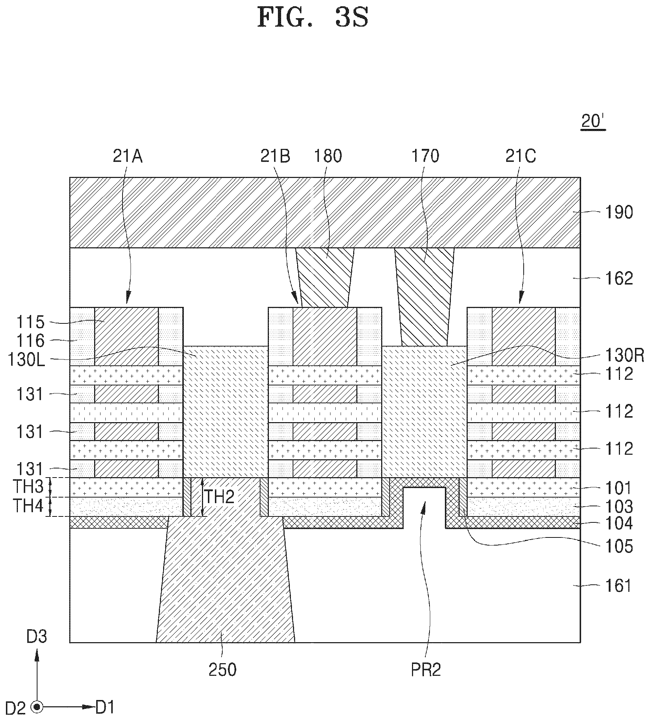

Subsequently, a frontside contact structure 170 and a gate contact structure 180 including a metal or metal compound may be formed on top surfaces of the gate structure 115 and the 2^{nd} source/drain region 130R, respectively, through the frontside isolation structure 162. The frontside contact structure 170 may connect the 2^{nd} source/drain region 130R to a voltage source or another circuit element. The gate contact structure 180 may receive a gate input signal for the gate structure 115. Here, a frontside contact structure may not be formed on a top surface of the 1^{st} source/drain region 130L because a backside contact structure 250 instead of the frontside contact structure may be formed in a later step (FIG. 3S) to connect the 1^{st} source/drain region 130L to a voltage source or another circuit element.

In addition, the BEOL structure 190 may be formed on the frontside isolation structure 162 to connect the frontside contact structure 170 and the gate contact structure 180 to a voltage source or other circuit elements through a plurality of metal lines and/or vias formed therein. The formation of the BEOL structure 190 may include one or more damascene processes.

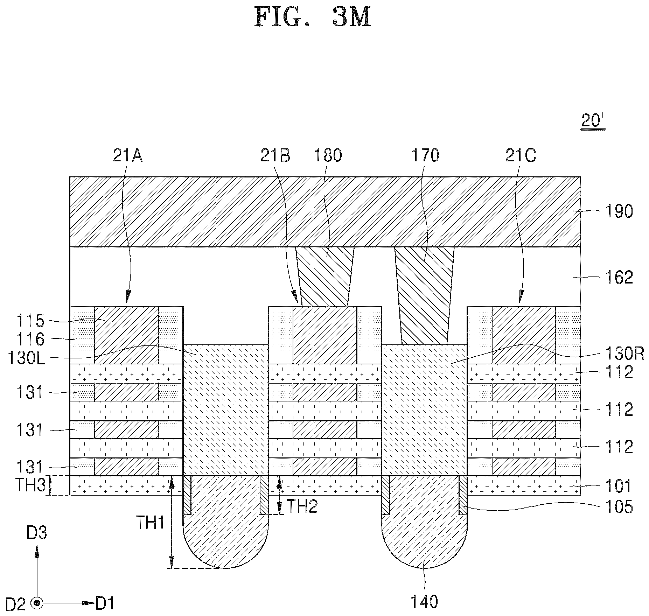

Referring to FIG. 3M, the substrate 101 may be removed to leave only top portions thereof at sides of the backside spacer 105.

As described earlier in reference to FIG. 2, the semiconductor device 20 manufactured from the intermediate semiconductor device 20' herein may dispense with the BDI layer 102 which requires a complicated process to form. Thus, at least to take over the function of the BDI layer 102 which is protecting and supporting the inner spacers 131 and the gate structure 115 in a subsequent backside process, the top portion of the substrate 101 may not be removed, and instead, remain as a substrate layer 101 under the bottom surfaces of the lowermost inner spacer 131 and the lowermost portion of the gate structure 115.

The partial removal of the substrate 101 in this step may be performed through, for example, dry etching, not being limited thereto, by a predetermined thickness to leave only the top portion of the substrate 101 as the substrate layers 101 below each of the channel stacks 21A-21C.

The substrate layers 101 may each be formed to have a 3^{rd} thickness TH3, which is smaller than the 2^{nd} thickness TH2 of the backside spacer 105, in the D3 direction so that current leakage from the gate structure 115 may be minimized and may not reach over the backside spacers 105.

The removal operation in this step and subsequent operations in manufacturing the semiconductor device may be performed by flipping upside down the intermediate semiconductor device 20' obtained in the previous step (FIG. 3L).

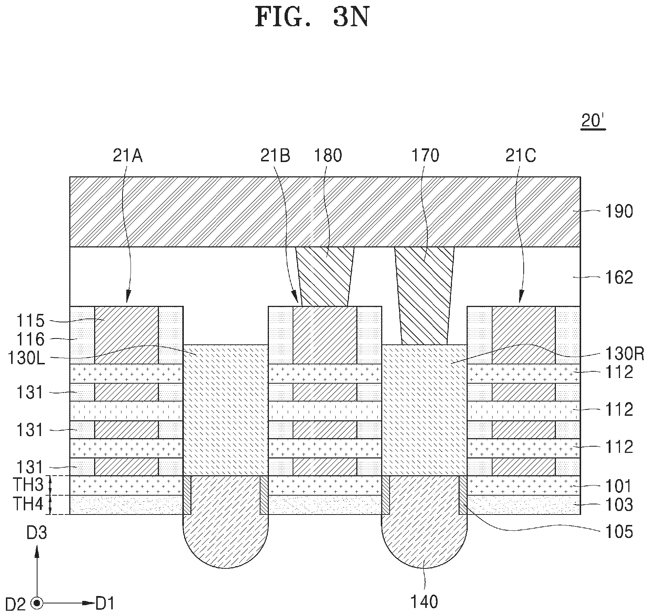

Referring to FIG. 3N, 1^{st} etch-stop layers 103 may be formed under the substrate layers 101 as dielectric passivation layer.

The 1^{st} etch-stop layer 103 formed in this step may prevent current leakage from the lower portions of the gate structure 115 through the substrate layer 101 to a backside isolation structure to be formed in a later step, which is a function of the BDI layer 102 in the semiconductor device 10 of FIGS. 1A and 1B.

The formation of the 1^{st} etch-stop layer 103 may be performed by depositing a material such as silicon nitride or a composite thereof (e.g., SiN, SiCN, SiBCN, etc.) on a bottom surface of the intermediate semiconductor device 20' obtained in the previous step through, for example, CVD, PVD, PECVD, ALD, or a combination thereof, followed by partial etching of the deposited material from bottom surfaces of the placeholder structure 140.

Thus, the 1^{st} etch-stop layers 103 may remain only on bottom surfaces of the 1^{st} substrate layers 101 in each of the channel stacks 21A-21C. The 1^{st} etch-stop layer 103 may be formed to have a 4^{th} thickness TH4, under the 1^{st} substrate layer 101, which is smaller than the 2^{nd} thickness TH2 of the backside spacer 105 in the D3 direction.

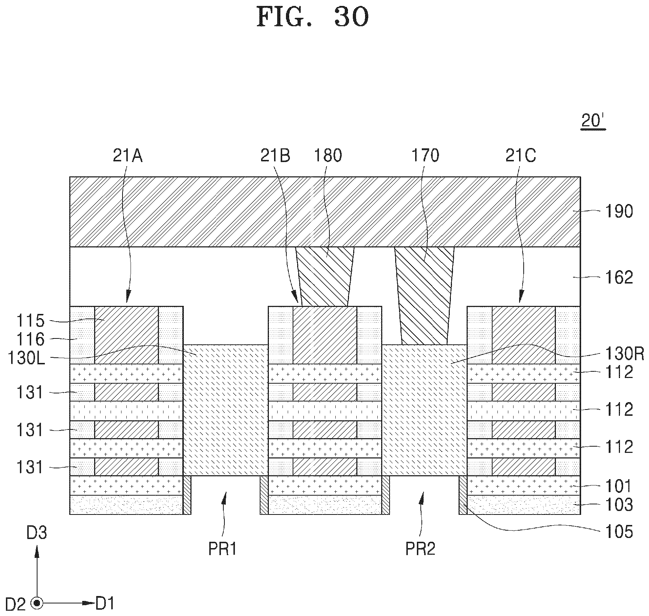

Referring to FIG. 3O, the placeholder structures 140 formed below the 1^{st} source/drain region 130L and the 2^{nd} source/drain region 130R may be removed based on the 1^{st} etch-stop layers 103 and the backside spacers 105 to reopen the placeholder recesses PR1 and PR2, through which bottom surfaces of the 1^{st} source/drain region 130L and the 2^{nd} source/drain region 130R are exposed, respectively.

When the placeholder structures 140 below the source/drain regions 130L and 130R are removed to reopen the placeholder recesses PR1 and PR2 with the backside spacers 105 on the side surfaces thereof, bottom surfaces of the source/drain regions 130L and 130R and side surfaces of the backside spacers 105 may be exposed in the placeholder recesses PR1 and PR2.

The removal of the placeholder structure 140 may be performed through, for example, wet etching or dry etching using an etchant such as hot phosphoric acid (H₃PO₄) or potassium hydroxide (KOH), not being limited thereto, which selectively etches the placeholder structures 140 of silicon germanium (SiGe) against the 1^{st} etch-stop layer 103 of silicon nitride or silicon oxide and the backside spacer 105 of silicon nitride.

When the placeholder structures 140 are removed from the intermediate semiconductor device 20' in this step, a possible risk of short-circuit between a backside contact structure to be formed in a later step and any of the placeholder structures 140 can be avoided when a semiconductor device including the backside contact structure is completed. In the meantime, even if the placeholder structures 140 are removed, the placeholder recesses PR1 and PR2 may be facilitated to identify a position where a backside contact structure is to be formed through a backside isolation structure in a later step (FIG. 3S).

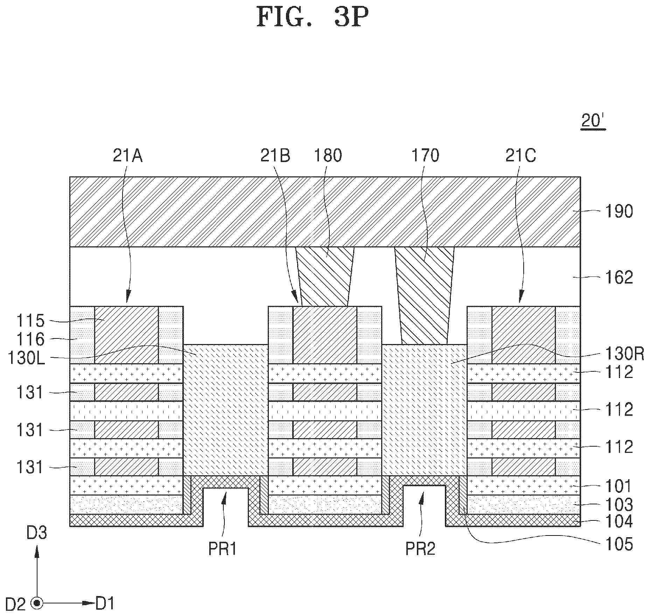

Referring to FIG. 3P, a 2^{nd} etch-stop layer 104 may be formed on a bottom surface of the intermediate semiconductor device 20' obtained in the previous step (FIG. 3O).

In this step, the 2^{nd} etch-stop layer 104 may be continuously and conformally formed on the bottom surface of the intermediate semiconductor device 20' which includes bottom surfaces of the 1^{st} etch-stop layers 103, the backside spacers 105 and the source/drain regions 130L and 130R, and the side surfaces of the backside spacers 105 through, for example, atomic layer deposition (ALD), not being limited thereto.

Thus, the placeholder recesses PR1 and PR2 are now defined by portions of the 2^{nd} etch-stop layer 104 formed on the side surfaces of the backside spacers 105 and the bottom surfaces of the source/drain regions 130L and 130R.

The material forming the 2^{nd} etch-stop layer 104 may include aluminum nitride or aluminum oxide (AIN, AlOₓ, etc.), not being limited thereto, having etch selectivity against the 1^{st} etch-stop layer 103 of silicon nitride or silicon oxide.

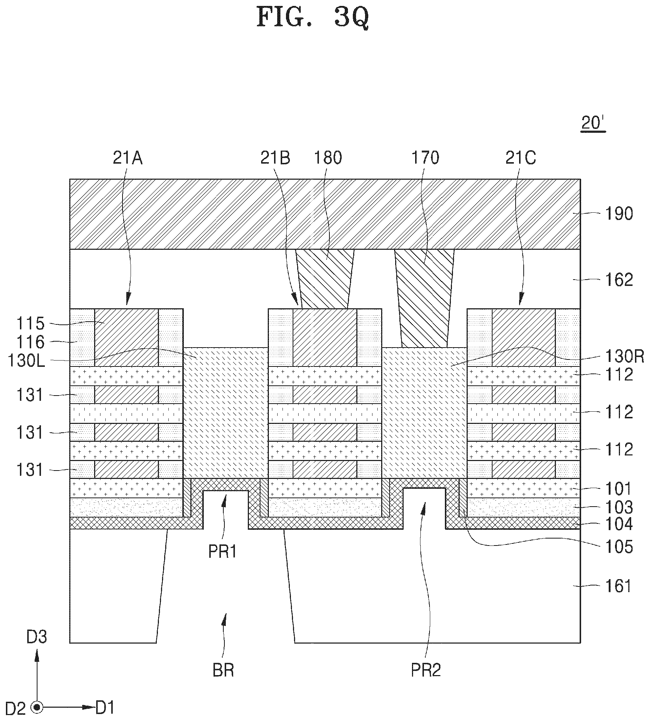

Referring to FIG. 3Q, a backside isolation structure 161 may be formed on a bottom surface of the intermediate semiconductor device 20' obtained in the previous step (FIG. 3P), and patterned based on the 2^{nd} etch-stop layer 104 to form a backside contact recess BR connected to the 1^{st} placeholder recess PR1 at a position where a backside contact structure 250 is to be formed in a later step (FIG. 3S).

The backside isolation structure 161 may be formed on a back side of the intermediate semiconductor device 20' where the 2^{nd} etch-stop layer 104 is formed, and patterned through, for example, photolithography, masking, and etching operations until the etching operation stops at the 2^{nd} etch-stop layer 104 through a backside contact recess BR formed below the 1^{st} source/drain region 130L and the 1^{st} placeholder recess PR1 obtained in the earlier step (FIG. 3O). Here, the 1^{st} source/drain region 130L is a target source/drain region to be connected to a backside contact structure in a later step (FIG. 3S), and the 1^{st} placeholder recess PR1 is a target placeholder recess formed below the target source/drain region.

In a case where the backside isolation structure 161 is formed of silicon oxide (e.g., SiO₂, etc.) and the 2^{nd} etch-stop layer 104 is formed of aluminum nitride or aluminum oxide (AIN, AlOₓ, etc.), an etchant such as hydrofluoric acid (HF) may be used to selectively remove the backside isolation structure 161 against the 2^{nd} etch-stop layer 104 through wet etching or dry etching.

The etching operation in this step may begin from a bottom surface of the backside isolation structure 161 at a position above which the 1^{st} source/drain region 130L is formed and continue until the backside contact recess BR is formed and the 1^{st} placeholder recess PR1 is reopened in a self-aligned manner to expose at least a portion of the 2^{nd} etch-stop layer 104 formed on the bottom surface of the 1^{st} source/drain region 130L and the bottom surfaces and the side surfaces of the backside spacers 105.

Subject to an etching process margin, portions of the 2^{nd} etch-stop layer 104 formed on bottom surfaces of portions of the 1^{st} etch-stop layers 103 may also be exposed.

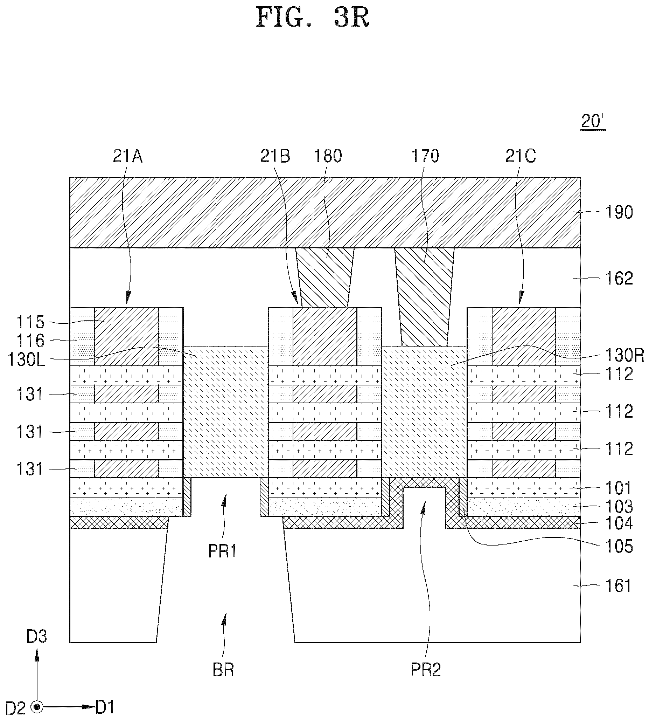

Referring to FIG. 3R, the portions of the 2^{nd} etch-stop layer 104 exposed through the backside contact recess BR and the 1^{st} placeholder recess PR1 may be removed by patterning thereon to expose the bottom surface of the 1^{st} source/drain region 130L and the bottom surfaces and the side surfaces of the backside spacers 105.

In this step, the patterning operation on the 2^{nd} etch-stop layer 104 may be performed through, for example, wet etching or dry etching using an etchant such as phosphoric acid (H₃PO₄) which selectively etches aluminum nitride or aluminum oxide forming the 2^{nd} etch-stop layer 104 against silicon or silicon germanium forming the 1^{st} source/drain region 120L, silicon nitride or a composite thereof forming the 1^{st} etch-stop layer 103 and the backside spacers 105.

Thus, the bottom surfaces of the 1^{st} source/drain region 130L and the side surfaces of the backside spacers 105 defining the 1^{st} placeholder recess PR1 is exposed through the 1^{st} placeholder recess PR1 and the backside contact recess BR. Further, the bottom surfaces of the backside spacers 105 and portions of the 1^{st} etch-stop layers 103 adjacent to the backside spacers 105 may also be exposed through the backside contact recess BR.

Referring to FIG. 3S, a backside contact structure 250 may be formed in the backside contact recess BR and the 1^{st} placeholder recess PR1 to contact the bottom surface of the 1^{st} source/drain region 130L while being isolated from the substrate layers 101 by the backside spacers 105 and the 1^{st} etch-stop layers 103.

The backside contact structure 250 may be formed by depositing a metal or metal in the backside contact recess BR and the 1^{st} placeholder recess PR1 through, for example, CVD, PVD, PECVD, or a combination thereof, not being limited thereto, such that the backside contact structure 250 contacts the bottom surface of the 1^{st} source/drain region 130L in a self-aligned manner based on the 1^{st} etch-stop layer 103, the 2^{nd} etch-stop layer 104 and the backside spacers 105 exposed in the backside contact recess BR.

Thus, the formation of the backside contact structure 250 in the above method may avoid a complicated process of forming a BDI layer, and also, may prevent a risk of misalignment between the backside contact structure 250 and the 1^{st} source/drain region 130L and a risk of short-circuit between with the backside contact structure 250 and a placeholder structure.

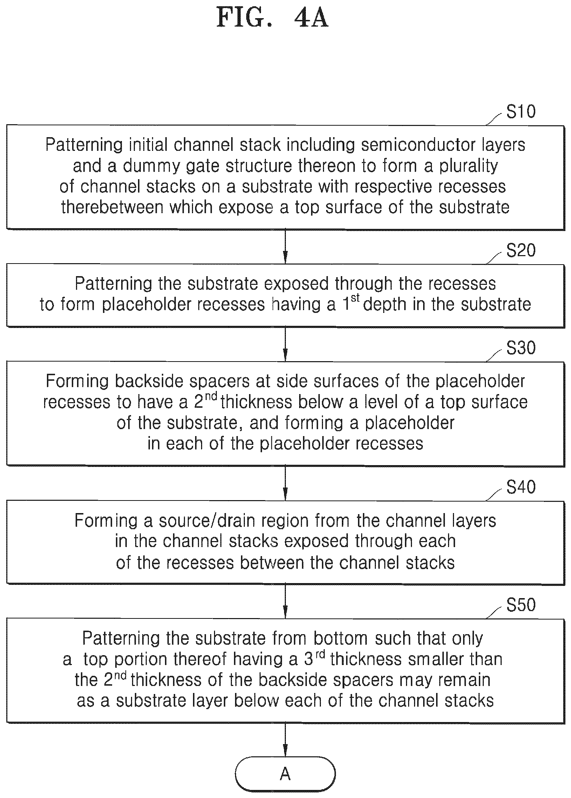

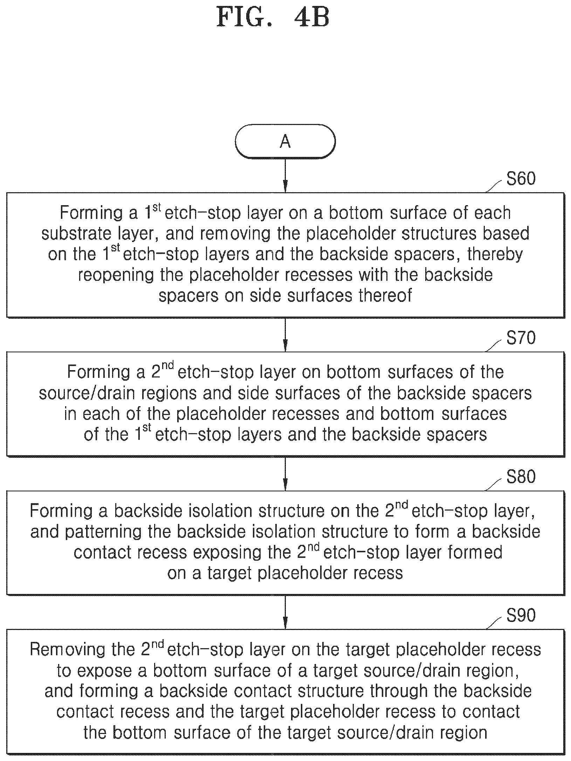

FIGS. 4A and 4B illustrate a flowchart describing a method of manufacturing a semiconductor device including a self-aligned backside contact structure and etch-stop layers in reference to FIGS. 3A-3S, according to one or more embodiments of the claimed invention.

In S10, an initial channel stack including a plurality of semiconductor layers and a dummy gate structure thereon may be patterned to form a plurality of channel stacks on a substrate with respective recesses therebetween which expose a top surface of the substrate (FIGS. 3A-3D). The semiconductor layers of the initial channel stack may include a plurality of sacrificial layers and channel layers alternatively stacked one by one on the substrate. These semiconductor layers may be epitaxially grown from the substrate.

In S20, the substrate exposed through the recesses may be patterned from top to form placeholder recesses having a 1^{st} depth in the substrate (FIGS. 3E-3G). At this time, the sacrificial layers in each channel stack may have been recessed at their side surfaces to form inner spacers thereon.

In S30, backside spacers are formed at side surfaces of the placeholder recesses to have a 2^{nd} thickness below a level of a top surface of the substrate, and a placeholder structure may be formed in each of the placeholder recesses (FIGS. 3H-3I).

In S40, a source/drain region may be formed from the channel layers in the channel stacks exposed through each of the recesses between the channel stacks (FIG. 3J). The source/drain regions may be epitaxially grown from the channel layers.

In S50, the substrate may be patterned from bottom such that only a top portion thereof having a 3^{rd} thickness smaller than the 2^{nd} thickness of the backside spacers may remain as a substrate layer below each of the channel stacks (FIGS. 3K-3M). At this time, a frontside process forming a frontside contact structure and a gate contact structure may have been performed.

In S60, a 1^{st} etch-stop layer may be formed on a bottom surface of each substrate layer, and the placeholder structures are removed based on the 1^{st} etch-stop layers and the backside spacers, thereby reopening the placeholder recesses with the backside spacers on side surfaces thereof (FIGS. 3N-3O).

In S70, a 2^{nd} etch-stop layer may be formed on a bottom surface of an intermediate semiconductor device obtained in the previous step (S60) such that the 2^{nd} etch-stop layer is conformally formed on bottom surfaces of the source/drain regions and side surfaces of the backside spacers in each of the placeholder recesses and bottom surfaces of the 1^{st} etch-stop layers and the backside spacers (FIG. 3P).

In S80, a backside isolation structure may be formed on the 2^{nd} etch-stop layer, and patterned to form a backside contact recess in the backside isolation structure which expose the 2^{nd} etch-stop layer formed on a target placeholder recess where a backside contact structure is to be formed (FIGS. 3Q).

In S90, the 2^{nd} etch-stop layer on the target placeholder recess is removed to expose a bottom surface of a target source/drain region, and a backside contact structure is formed through the backside contact recess and the target placeholder recess to contact the bottom surface of the target source/drain region (FIG. 3S).

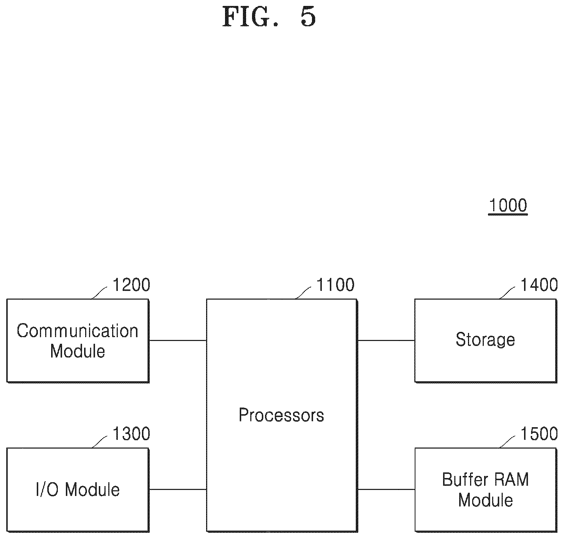

FIG. 5 is a schematic block diagram illustrating an electronic device including a self-aligned backside contact structure and etch-stop layers as shown in FIG. 2, according to one or more embodiments of the claimed invention.

Referring to FIG. 5, an electronic device 1000 may include at least one processor 1100, a communication module 1200, a I/O module 1300, a storage 1400, and a buffer RAM module 1500. The electronic device 1000 may be a mobile device such as a smartphone or a tablet computer, not being limited thereto, according to embodiments of the claimed invention.

The processor 1100 may control operations of the electronic device 1000. The communication module 1200 is implemented to perform wireless or wire communications with an external device. The I/O module 1300 is implemented to display data processed by the processor 1100 and/or to receive data through a touch panel. The storage 1400 is implemented to store user data. The storage 1400 may be an embedded multimedia card (eMMC), a solid state drive (SSD), a universal flash storage (UFS) device, etc. The storage 1400 may perform caching of the mapping data and the user data as described above.

The buffer RAM module 1500 may temporarily store data used for processing operations of the electronic device 1000. For example, the buffer RAM module 1500 may be volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

At least one component in the electronic device 1000 may include one or more semiconductor devices semiconductor devices including a backside contact structure as shown in FIG. 2.

The foregoing is illustrative of exemplary embodiments of the claimed invention and is not to be construed as limiting the disclosure. Although a few exemplary embodiments have been described, those skilled in the art will readily appreciate that many modifications are possible in the above embodiments within the scope as defined by the appended claims.

## Claims

1. A semiconductor device comprising:
a channel structure including a plurality of channel layers (112) stacked on each other in a vertical direction (D3);
a gate structure (115) on the channel structure;
a 1^{st} source/drain region (130L) and a 2^{nd} source/drain region (130R) on opposite sides of the channel structure in a horizontal direction (D1) and connected to each other by the channel structure;
a substrate layer (101) below the gate structure (115);
a 1^{st} etch-stop layer (103) below the substrate layer (101);
a backside spacer (105) on a side surface of the substrate layer (101); and
a backside contact structure (250) on a bottom surface of the 1^{st} source/drain region (130L) and a side surface and a bottom surface of the backside spacer (105), and
**characterized in that**
the backside spacer (105) is also on a side surface of the 1^{st} etch-stop layer (103), and
the backside contact structure (250) is also formed on a bottom surface of a portion of the 1^{st} etch-stop layer (103).

2. The semiconductor device of claim 1, wherein the substrate layer (101) has a smaller thickness than the backside spacer (105) in the vertical direction (D3).

3. The semiconductor device of claim 1 or 2, wherein the substrate layer (101) comprises silicon, and each of the backside spacer (105) and the 1^{st} etch-stop layer (103) comprises silicon nitride or a composite thereof.

4. The semiconductor device of any one of claims 1 to 3, further comprising:
a 2^{nd} etch-stop layer (104) below the 1^{st} etch-stop layer (103); and
a backside isolation structure (161) on the backside contact structure (250) and the 2^{nd} etch-stop layer (104).

5. The semiconductor device of claim 4, wherein the backside contact structure (250) penetrates into the 2^{nd} etch-stop layer (104) to be formed on the bottom surface of the 1^{st} source/drain region (130L).

6. The semiconductor device of claim 4 or 5, wherein the 2^{nd} etch-stop layer (104) comprises a material having etch selectivity against the backside spacer (105) and the 1^{st} etch-stop layer (103).

7. The semiconductor device of claim 6, wherein the material of the 2^{nd} etch-stop layer (104) comprises aluminum oxide or aluminum nitride.

8. The semiconductor device of any one of claims 4 to 7, further comprising:
a frontside contact structure (170) on a top surface of the 2^{nd} source/drain region (130R).

9. The semiconductor device of claim 8, wherein the 2^{nd} etch-stop layer (104) is formed on a bottom surface of the 2^{nd} source/drain region (130R).

10. The semiconductor device of claim 4 to 9, wherein a placeholder structure is not formed in the backside isolation structure (161) below the 2^{nd} source/drain region (130R).

11. A method of manufacturing a semiconductor device;
forming a channel structure on a substrate and a gate structure (115) on the channel structure, the channel structure including a plurality of channel layers (112) stacked on each other in a vertical direction (D3);
forming a placeholder recess (PR1) in the substrate (101);
forming a backside spacer (105) on a side surface of the placeholder recess (PR1);
forming a 1^{st} source/drain region (130L) and a 2^{nd} source/drain region (130R) on opposite sides of the channel structure in a horizontal direction (D1) and connected to each other by the channel structure;
forming a substrate layer (101) below the gate structure (115) from the substrate (101) so that the substrate layer (101) is disposed at a 1^{st} side of the backside spacer (105) on a side surface of the backside spacer (105);
forming a 1^{st} etch-stop layer (103) below the substrate layer (101) at the 1^{st} side of the backside spacer (105) on the side surface of the backside spacer (105); and
forming a backside contact structure (250) in the placeholder recess (PR1) on a bottom surface of the 1^{st} source/drain region (130L) and a side surface and a bottom surface of the backside spacer (105) and a bottom surface of a portion of the 1^{st} etch-stop layer (103) such that the backside contact structure (250) is isolated from the substrate layer (101) by the backside spacer (105) and the 1^{st} etch-stop layer (103).

12. The method of claim 11, wherein the forming the backside contact structure (250) is performed such that an upper portion of the backside contact structure (250) is formed at a 2^{nd} side of the backside spacer (105) opposite to the 1^{st} side.

13. The method of claim 11 or 12, further comprising:
forming a 2^{nd} etch-stop layer (104) on a bottom surface of the 1^{st} etch-stop layer (103), a bottom surface of the backside spacer (105) and a bottom surface of the 1^{st} source/drain region (130L), and a side surface of the backside spacer (105);
forming a backside isolation structure (161) on the 2^{nd} etch-stop layer (104); and
patterning the backside isolation structure (161) based on the 2^{nd} etch-stop layer (104) to expose the bottom surface of the 1^{st} source/drain region (130L) and the side surface of the backside spacer (105).

14. The method of claim 11 to 13, wherein the substrate layer (101) is formed to have a smaller thickness than the backside spacer (105) in a direction in which the gate structure (115), the substrate layer (101), and the 1^{st} etch-stop layer (103) are arranged.

## Patentansprüche

1. Halbleitervorrichtung, aufweisend:
eine Kanalstruktur, die eine Vielzahl von Kanalschichten (112) aufweist, die in einer vertikalen Richtung (D3) übereinander gestapelt sind;
eine Gate-Struktur (115) auf der Kanalstruktur;
einen ersten Source/Drain-Bereich (130L) und einen zweiten Source/Drain-Bereich (130R) an gegenüberliegenden Seiten der Kanalstruktur in einer horizontalen Richtung (D1), die durch die Kanalstruktur miteinander verbunden sind;
eine Substratschicht (101) unter der Gate-Struktur (115);
eine erste Ätzstoppschicht (103) unter der Substratschicht (101);
einen rückseitigen Abstandshalter (105) an einer Seitenfläche der Substratschicht (101); und
eine rückseitige Kontaktstruktur (250) an einer unteren Oberfläche des ersten Source/Drain-Bereichs (130L) und an einer Seitenfläche und einer unteren Oberfläche des rückseitigen Abstandshalters (105), und
**dadurch gekennzeichnet, dass**
der rückseitige Abstandshalter (105) auch an einer Seitenfläche der ersten Ätzstoppschicht (103) angeordnet ist, und
die rückseitige Kontaktstruktur (250) auch an einer unteren Oberfläche eines Abschnitts der ersten Ätzstoppschicht (103) ausgebildet ist.

2. Halbleitervorrichtung nach Anspruch 1, wobei die Substratschicht (101) in der vertikalen Richtung (D3) eine geringere Dicke als der rückseitige Abstandshalter (105) aufweist.

3. Halbleitervorrichtung nach Anspruch 1 oder 2, wobei die Substratschicht (101) Silizium aufweist und jeder von dem rückseitigen Abstandshalter (105) und der ersten Ätzstoppschicht (103) Siliziumnitrid oder einen Verbundstoff davon aufweist.

4. Halbleitervorrichtung nach einem der Ansprüche 1 bis 3, ferner aufweisend:
eine zweite Ätzstoppschicht (104) unter der ersten Ätzstoppschicht (103); und
eine rückseitige Isolationsstruktur (161) auf der rückseitigen Kontaktstruktur (250) und der zweiten Ätzstoppschicht (104).

5. Halbleitervorrichtung nach Anspruch 4, wobei die rückseitige Kontaktstruktur (250) in die zweite Ätzstoppschicht (104) eindringt, um an der unteren Oberfläche des ersten Source/Drain-Bereichs (130L) ausgebildet zu sein.

6. Halbleitervorrichtung nach Anspruch 4 oder 5, wobei die zweite Ätzstoppschicht (104) ein Material aufweist, das eine Ätzselektivität gegenüber dem rückseitigen Abstandshalter (105) und der ersten Ätzstoppschicht (103) aufweist.

7. Halbleitervorrichtung nach Anspruch 6, wobei das Material der zweiten Ätzstoppschicht (104) Aluminiumoxid oder Aluminiumnitrid aufweist.

8. Halbleitervorrichtung nach einem der Ansprüche 4 bis 7, ferner aufweisend:
eine vorderseitige Kontaktstruktur (170) auf einer oberen Oberfläche des zweiten Source/Drain-Bereichs (130R).

9. Halbleitervorrichtung nach Anspruch 8, wobei die zweite Ätzstoppschicht (104) an einer unteren Oberfläche des zweiten Source/Drain-Bereichs (130R) ausgebildet ist.

10. Halbleitervorrichtung nach einem der Ansprüche 4 bis 9, wobei keine Platzhalterstruktur in der rückseitigen Isolationsstruktur (161) unter dem zweiten Source/Drain-Bereich (130R) ausgebildet ist.

11. Verfahren zur Herstellung einer Halbleitervorrichtung, aufweisend:
Bilden einer Kanalstruktur auf einem Substrat und einer Gate-Struktur (115) auf der Kanalstruktur, wobei die Kanalstruktur eine Vielzahl von Kanalschichten (112) aufweist, die in einer vertikalen Richtung (D3) übereinander gestapelt sind;
Bilden einer Platzhalteraussparung (PR1) in dem Substrat (101);
Bilden eines rückseitigen Abstandshalters (105) an einer Seitenfläche der Platzhalteraussparung (PR1);
Bilden eines ersten Source/Drain-Bereichs (130L) und eines zweiten Source/Drain-Bereichs (130R) an gegenüberliegenden Seiten der Kanalstruktur in einer horizontalen Richtung (D1), die durch die Kanalstruktur miteinander verbunden sind;
Bilden einer Substratschicht (101) unter der Gate-Struktur (115) aus dem Substrat (101), so dass die Substratschicht (101) an einer ersten Seite des rückseitigen Abstandshalters (105) an einer Seitenfläche des rückseitigen Abstandshalters (105) angeordnet ist;
Bilden einer ersten Ätzstoppschicht (103) unter der Substratschicht (101) an der ersten Seite des rückseitigen Abstandshalters (105) an der Seitenfläche des rückseitigen Abstandshalters (105); und
Bilden einer rückseitigen Kontaktstruktur (250) in der Platzhalteraussparung (PR1) an einer unteren Oberfläche des ersten Source/Drain-Bereichs (130L) und an einer Seitenfläche und einer unteren Oberfläche des rückseitigen Abstandshalters (105) und an einer unteren Oberfläche eines Abschnitts der ersten Ätzstoppschicht (103), so dass die rückseitige Kontaktstruktur (250) durch den rückseitigen Abstandshalter (105) und die erste Ätzstoppschicht (103) von der Substratschicht (101) isoliert ist.

12. Verfahren nach Anspruch 11, wobei das Bilden der rückseitigen Kontaktstruktur (250) derart durchgeführt wird, dass ein oberer Abschnitt der rückseitigen Kontaktstruktur (250) an einer zweiten Seite des rückseitigen Abstandshalters (105) ausgebildet wird, die der ersten Seite gegenüberliegt.

13. Verfahren nach Anspruch 11 oder 12, ferner aufweisend:
Bilden einer zweiten Ätzstoppschicht (104) an einer unteren Oberfläche der ersten Ätzstoppschicht (103), einer unteren Oberfläche des rückseitigen Abstandshalters (105) und einer unteren Oberfläche des ersten Source/Drain-Bereichs (130L) sowie an einer Seitenfläche des rückseitigen Abstandshalters (105);
Bilden einer rückseitigen Isolationsstruktur (161) auf der zweiten Ätzstoppschicht (104); und
Strukturieren der rückseitigen Isolationsstruktur (161) basierend auf der zweiten Ätzstoppschicht (104), um die untere Oberfläche des ersten Source/Drain-Bereichs (130L) und die Seitenfläche des rückseitigen Abstandshalters (105) freizulegen.

14. Verfahren nach einem der Ansprüche 11 bis 13, wobei die Substratschicht (101) so ausgebildet wird, dass sie eine geringere Dicke als der rückseitige Abstandshalter (105) in einer Richtung aufweist, in der die Gate-Struktur (115), die Substratschicht (101) und die erste Ätzstoppschicht (103) angeordnet sind.

## Revendications

1. Dispositif à semi-conducteur comprenant :
une structure de canal comprenant une pluralité de couches de canal (112) empilées les unes sur les autres dans une direction verticale (D3) ;
une structure de grille (115) sur la structure de canal ;
une première région source/drain (130L) et une deuxième région source/drain (130R) de part et d'autre de la structure de canal dans une direction horizontale (D1) et reliées l'une à l'autre par la structure de canal ;
une couche de substrat (101) sous la structure de grille (115) ;
une première couche d'arrêt de gravure (103) sous la couche de substrat (101) ;
un espaceur de face arrière (105) sur une surface latérale de la couche de substrat (101) ; et
une structure de contact de face arrière (250) sur une surface inférieure de la première région source/drain (130L) et sur une surface latérale et une surface inférieure de l'espaceur de face arrière (105), et
**caractérisé en ce que**
l'espaceur de face arrière (105) est également sur une surface latérale de la première couche d'arrêt de gravure (103), et
la structure de contact de face arrière (250) est également formée sur une surface inférieure d'une portion de la première couche d'arrêt de gravure (103).

2. Dispositif à semi-conducteur selon la revendication 1, dans lequel la couche de substrat (101) a une épaisseur inférieure à celle de l'espaceur de face arrière (105) dans la direction verticale (D3).

3. Dispositif à semi-conducteur selon la revendication 1 ou 2, dans lequel la couche de substrat (101) comprend du silicium, et chacun de l'espaceur de face arrière (105) et de la première couche d'arrêt de gravure (103) comprend du nitrure de silicium ou un composite de celui-ci.

4. Dispositif à semi-conducteur selon l'une quelconque des revendications 1 à 3, comprenant en outre :
une deuxième couche d'arrêt de gravure (104) sous la première couche d'arrêt de gravure (103) ; et
une structure d'isolation de face arrière (161) sur la structure de contact de face arrière (250) et la deuxième couche d'arrêt de gravure (104).

5. Dispositif à semi-conducteur selon la revendication 4, dans lequel la structure de contact de face arrière (250) pénètre dans la deuxième couche d'arrêt de gravure (104) de manière à être formée sur la surface inférieure de la première région source/drain (130L).

6. Dispositif à semi-conducteur selon la revendication 4 ou 5, dans lequel la deuxième couche d'arrêt de gravure (104) comprend un matériau ayant une sélectivité de gravure par rapport à l'espaceur de face arrière (105) et à la première couche d'arrêt de gravure (103).

7. Dispositif à semi-conducteur selon la revendication 6, dans lequel le matériau de la deuxième couche d'arrêt de gravure (104) comprend de l'oxyde d'aluminium ou du nitrure d'aluminium.

8. Dispositif à semi-conducteur selon l'une quelconque des revendications 4 à 7, comprenant en outre :
une structure de contact de face avant (170) sur une surface supérieure de la deuxième région source/drain (130R).

9. Dispositif à semi-conducteur selon la revendication 8, dans lequel la deuxième couche d'arrêt de gravure (104) est formée sur une surface inférieure de la deuxième région source/drain (130R).

10. Dispositif à semi-conducteur selon l'une quelconque des revendications 4 à 9, dans lequel aucune structure de réservation n'est formée dans la structure d'isolation de face arrière (161) sous la deuxième région source/drain (130R).

11. Procédé de fabrication d'un dispositif à semi-conducteur, le procédé comprenant :
la formation d'une structure de canal sur un substrat et d'une structure de grille (115) sur la structure de canal, la structure de canal comprenant une pluralité de couches de canal (112) empilées les unes sur les autres dans une direction verticale (D3) ;
la formation d'un évidement de réservation (PR1) dans le substrat (101) ;
la formation d'un espaceur de face arrière (105) sur une surface latérale de l'évidement de réservation (PR1) ;
la formation d'une première région source/drain (130L) et d'une deuxième région source/drain (130R) de part et d'autre de la structure de canal dans une direction horizontale (D1) et reliées l'une à l'autre par la structure de canal ;
la formation d'une couche de substrat (101) sous la structure de grille (115) à partir du substrat (101), de sorte que la couche de substrat (101) soit disposée d'un premier côté de l'espaceur de face arrière (105), sur une surface latérale de l'espaceur de face arrière (105) ;
la formation d'une première couche d'arrêt de gravure (103) sous la couche de substrat (101), dudit premier côté de l'espaceur de face arrière (105), sur la surface latérale de l'espaceur de face arrière (105) ; et
la formation d'une structure de contact de face arrière (250) dans l'évidement de réservation (PR1) sur une surface inférieure de la première région source/drain (130L) et sur une surface latérale et une surface inférieure de l'espaceur de face arrière (105) et sur une surface inférieure d'une portion de la première couche d'arrêt de gravure (103), de telle sorte que la structure de contact de face arrière (250) soit isolée de la couche de substrat (101) par l'espaceur de face arrière (105) et la première couche d'arrêt de gravure (103).

12. Procédé selon la revendication 11, dans lequel la formation de la structure de contact de face arrière (250) est effectuée de telle sorte qu'une portion supérieure de la structure de contact de face arrière (250) soit formée d'un deuxième côté de l'espaceur de face arrière (105) opposé au premier côté.

13. Procédé selon la revendication 11 ou 12, comprenant en outre :
la formation d'une deuxième couche d'arrêt de gravure (104) sur une surface inférieure de la première couche d'arrêt de gravure (103), une surface inférieure de l'espaceur de face arrière (105) et une surface inférieure de la première région source/drain (130L), ainsi que sur une surface latérale de l'espaceur de face arrière (105) ;
la formation d'une structure d'isolation de face arrière (161) sur la deuxième couche d'arrêt de gravure (104) ; et
la structuration de la structure d'isolation de face arrière (161) sur la base de la deuxième couche d'arrêt de gravure (104) pour exposer la surface inférieure de la première région source/drain (130L) et la surface latérale de l'espaceur de face arrière (105).

14. Procédé selon l'une quelconque des revendications 11 à 13, dans lequel la couche de substrat (101) est formée de manière à avoir une épaisseur inférieure à celle de l'espaceur de face arrière (105) dans une direction dans laquelle la structure de grille (115), la couche de substrat (101) et la première couche d'arrêt de gravure (103) sont agencées.
